Europäisches Patentamt

European Patent Office

Office européen des brevets

(19)

(11) Numéro de publication: **0 027 070**
**B1**

(12) **FASCICULE DE BREVET EUROPEEN**

(45) Date de publication du fascicule du brevet:
**06.04.83**

(51) Int. Cl.³: **H 01 L 31/02, G 02 B 7/26**

(21) Numéro de dépôt: **80401335.7**

(22) Date de dépôt: **19.09.80**

(54) Tête de couplage opto-électronique, et procédé de montage d'une telle tête.

(30) Priorité: **05.10.79 FR 7924892**

(43) Date de publication de la demande:
**15.04.81 Bulletin 81/15**

(45) Mention de la délivrance du brevet:
**06.04.83 Bulletin 83/14**

(84) Etats contractants désignés:
**DE GB IT NL**

(56) Documents cités:
**FR-A-2 045 488**
**FR-A-2 446 497**

**IEEE TRANSACTIONS ON ELECTRON DEVICES, vol. ED-24, no. 7, juillet 1977 New York US MASAYUKI ABE et al.: «High-Efficiency Long-Lived GaA1As LED's for Fiber-Optical Communications» pages 990–994**

(73) Titulaire: **THOMSON-CSF, 173, Boulevard Haussmann, F-75379 Paris Cedex 08 (FR)**

(72) Inventeur: **Simon, Jacques, "THOMSON-CSF" SCPI 173, Bld Haussmann, F-75360 Paris Cedex 08 (FR)**
Inventeur: **Defaut, Bernard, "THOMSON-CSF" SCPI 173, Bld Haussmann, F-75360 Paris Cedex 08 (FR)**

(74) Mandataire: **Giraud, Pierre et al, THOMSON-CSF SCPI 173, Bld Haussmann, F-75379 Paris Cedex 08 (FR)**

Tête de couplage opto-électronique, et procédé de montage d'une telle tête.

L'invention concerne une tête de couplage opto-électronique qui peut être soit une tête d'émission soit une tête de réception (ou détection).

On sait qu'une liaison de télécommunication par fibre optique peut comporter:

– une tête d'émission comportant un émetteur optique modulé par l'information à transmettre, émetteur qui est par exemple une diode électroluminescente ou une diode laser, couplé avec un tronçon de fibre optique;

– au moins un connecteur couplant le tronçon de fibre optique avec une ou plusieurs fibres optiques;

– au moins un câble optique comprenant un nombre variable de fibres dont une ou plusieurs sont affectuées à la transmission de l'information provenant de l'émetteur;

– au moins un connecteur couplant la ou les fibres optiques intéressées par la transmission dont il s'agit avec un tronçon de fibre optique;

– une tête de réception (ou de détection) comportant un tronçon de fibre optique couplé avec un récepteur (ou détecteur) optique (photodiode) restituant l'information sous forme électrique.

Une liaison complète comporte une liaison du type ci-dessus dans chaque sens de transmission.

La réalisation d'une tête d'émission ou de réception pose des problèmes:

– d'ordre mécanique, car il faut assurer le positionnement et l'immobilisation dans la position optimale, du composant opto-électronique (émetteur ou récepteur) par rapport à la surface terminale (d'entrée ou de sortie) du tronçon de fibre optique;

– d'ordre électrique et optique, en ce qui concerne notamment l'étanchéité des composants de manière à assurer et à présenter un bon isolement électrique des constituants de la tête, et les qualités optiques des organes optiques ou opto-électroniques.

Les réalisations connues sont complexes et d'un coût élevé de fabrication, surtout avec des fibres de télécommunications d'un très petit diamètre (par exemple de l'ordre de 100 microns), notamment par suite de la nécessité de procéder à un montage de la fibre dans la tête de couplage en contrôlant, en cours de montage, la bonne qualité de la transmission optique, suivant la méthode dite de «réglage dynamique».

Dans une réalisation plus simple, on utilise un porte-fibre percé au calibre de la fibre optique, le porte-fibre étant conçu pour être utilisé comme capot de protection de la tête. Mais cette solution exige de constituer le porte-fibre en utilisant un matériau tel que le nickel ou un alliage de fer, nickel et cobalt soudable à l'embase du type utilisé dans la technologie des semiconducteurs. Or ces matériaux présentent l'inconvénient d'être extrêmement difficiles à percer sur des longueurs relativement importantes par rapport au diamètre de la perforation, c'est-à-dire au diamètre d'une fibre optique de télécommunications.

Un document de l'art connu, à savoir le fascicule de brevet FR-A-2 405 488 décrit un dispositif optique pour connecteur destiné à la transmission par fibres.

Ce dispositif comprend un porte-fibre muni d'une cavité dans laquelle vient se loger un dispositif opto-électronique, ledit porte-fibre étant maintenu par compression entre une partie inférieure et une partie supérieure du connecteur.

L'invention utilise un boîtier normalisé avec capot et embase de semiconducteur, en évitant les inconvénients des réalisations précédentes.

La tête de couplage opto-électronique selon l'invention est du type comprenant un dispositif support d'un composant opto-électronique, le composant opto-électronique lui-même, un dispositif de positionnement de fibre optique, dit porte-fibre, un tronçon de fibre optique, enfin un dispositif d'encapsulation constitué par un boîtier classique de semiconducteur comprenant une embase et un capot percé d'une ouverture circulaire par laquelle le porte-fibre sort du boîtier, le porte-fibre étant maintenu par compression entre cette embase et ce capot, ce porte-fibre comportant dans la partie prenant appui sur l'embase un évidement dans lequel se loge le composant opto-électronique, caractérisé en ce que le porte-fibre comporte en outre dans sa partie opposée, un épaulement, sur la face annulaire duquel s'appuie le bord de cette ouverture circulaire du capot pratiquée dans une partie préalablement emboutie de la partie centrale supérieure de ce capot.

L'invention sera mieux comprise, et d'autres caractéristiques apparaîtront, au moyen de la description qui suit, et des dessins qui l'accompagnent, parmi lesquelles:

La figure 1 est une coupe schématique d'une tête d'émission suivant l'invention;

Les figures 2, 3 et 4 représentent diverses étapes de fabrication et/ou de montage de la tête représentée figure 1;

La figure 5 représente une variante de l'invention.

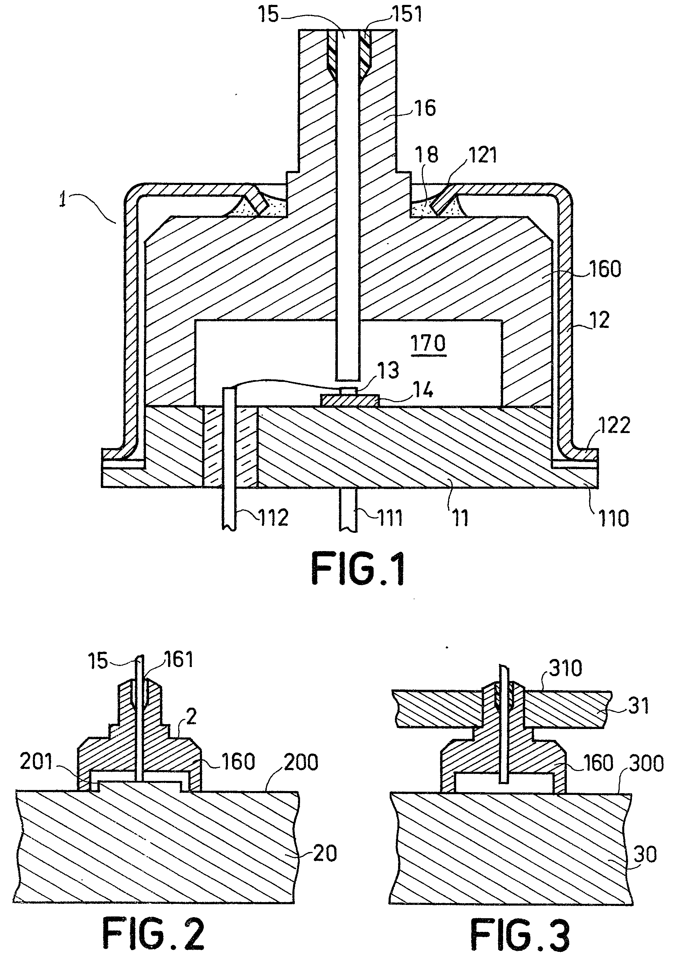

Dans le schéma de la figure 1, relatif à une tête d'émission, un boîtier 1, du type normalisé pour dispositif à semiconducteurs, comporte une embase 11, par exemple en alliage de fer, nickel et cobalt, de coefficient de dilatation proche de celui du verre, et un capot métallique 12. L'embase est traversée par des passages isolants de connexions électriques 111 et 112, du type «à perle de verre», destinés à alimenter le composant opto-électronique de la tête. Dans le cas de la figure 1, il s'agit par exemple d'une diode électroluminescente 13 montée sur un support 14. Ce dernier est par exemple une rondelle de céramique métallisée sur deux faces opposées, ou sur la seule face qui reçoit la diode, la connexion de masse 111 étant soudée sur cette dernière face métallisée. Le support 14 pourrait être aussi constitué par une rondelle métallique de cuivre destinée à faciliter la dissipation thermique, ce qui peut être nécessaire dans le cas d'un émetteur opto-électronique relativement puissant. Dans ce dernier cas, la connexion 111 serait inutile, la masse pouvant être prise en n'importe quel point de l'embase ou du capot. Enfin le support 14 peut être de forme parallélépipèdique.

Dans le même schéma, on a représenté figure 1, un porte-fibre 16 dont la partie médiane comporte un épaulement 160 de diamètre égal au diamètre interne du capot, diminué de 0,01 mm, avec une tolérance du même ordre par défaut. Ce porte-fibre enserre une fibre 15, immobilisée par de la colle, résine ou soudure, notamment à la partie supérieure du porte-fibre par un dépôt 151. L'épaulement 160 comporte un évidement 170, fournissant ainsi un logement pour le composant et ses connexions, avec un jeu vertical permettant de régler au mieux le couplage du composant et de la face d'entrée (ou de sortie dans le cas d'une tête de réception) de la fibre optique.

La partie supérieure du porte-fibre 16 émerge de la partie supérieure du capot 12 par une ouverture centrale dont le bord 121 est incliné vers le bas. Un dépôt 18 de colle, de résine ou de soudure est déposé autour du porte-fibre pour sceller le capot sur l'épaulement 160. On décrit plus loins l'étape où s'effectue ce dépôt.

En outre l'embase 11 comporte un rebord 110, de moindre épaisseur que la partie centrale, afin de faciliter la soudure électrique du bord évasé 122 du capot 12 sur la périphérie de l'embase 11. Cette opération de soudure est décrite plus loins.

Le procédé de fabrication et de montage du porte-fibre et de l'ensemble de la tête comporte par exemple les étapes suivantes:

a) Fabrication au tour du porte-fibre, comportant notamment l'usinage de l'épaulement 160, d'un épaulement supplémentaire 2 servant à fournir un plan de référence de la position des faces terminales du tronçon de fibre optique, et comprenant en outre le perçage d'un orifice axial;

b) Fixation de la fibre dans la perforation centrale du porte-fibre de manière à placer l'une des faces terminales de la fibre dans le plan correspondant au couplage optimal de cette face et du composant opto-électronique.

On utilise à cet effet un outillage 20 (figure 2), comportant un plan de référence 200 et une plateforme 201 dont la hauteur est égale à la cote de la face photo-émettrice ou photo-réceptrice du composant augmentée d'un intervalle calculé en fonction du couplage optimal déjà mentionné.

On fait coulisser le tronçon 15 dans la perforation centrale du porte-fibre 16 jusqu'à ce qu'il bute contre la plateforme 201, puis on immobilise la fibre en remplissant de colle, résine ou soudure une partie élargie 161 de la perforation centrale, située par exemple à la partie supérieure de celle-ci.

c) Rodage et plissage de la partie supérieure du porte-fibre et de la fibre elle-même en utilisant un outillage 30 comportant un plan d'appui 300, servant à supporter au cours de cette étape la partie inférieure 160 du porte-fibre, et comportant en outre un collier 31 prenant appui sur l'épaulement 2 du porte-fibre et dont la face supérieure 310 définit un plan-limite du rodage et du polissage;

d) Emboutissage et perçage du capot en utilisant des moyens classiques auxquels sont adjoints des outillages adaptés aux dimensions du capot 12;

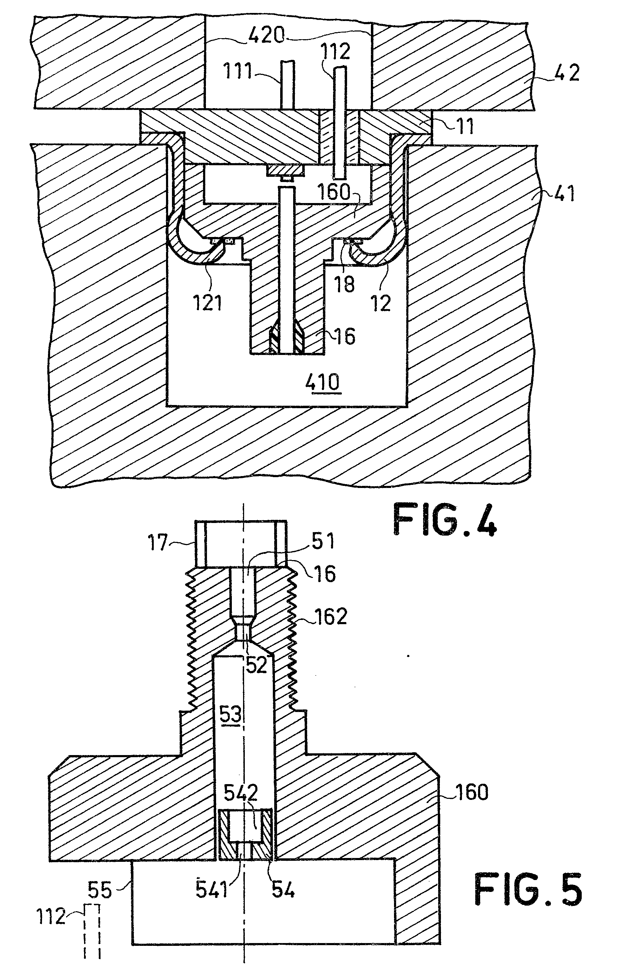

e) Scellement du capot en utilisant des moyens de soudure électrique comportant des électrodes façonnées pour s'adapter à la tête. En effet les électrodes doivent comprimer l'épaulement 160 du porte-fibre contre le bord circulaire 121 du capot 12 pendant l'opération. On a représenté partiellement, figure 4, les électrodes 41 et 42 de la machine à souder électrique utilisée dans cette opération. L'électrode 42 appuie sur l'embase 11; elle comporte une ouverture circulaire 420 destinée à laisser passer les connexions 111 et 112 afin d'eviter leur écrasement. L'électrode 41 comporte une cavité 410 destinée à recevoir le capot 12 embouti et percé préalablement. La profondeur de cette cavité est asses grande pour laisser libre le sommet 16 du porte-fibre 160 pendant l'opération de soudure électrique. On a représenté entre le capot et l'épaulement 160 une préforme de soudure à basse température destinée à jouer le rôle du dépôt 18 de la figure 1.

L'invention a plusieurs variantes, portant notamment sur le porte-fibre. On a représenté figure 5, un porte-fibre présentant des particularités correspondant aux variantes ci-après:

1) La partie supérieure 16 du porte-fibre comporte en complément d'un centreur mécanique 17 de forme cylindrique un filetage 162 permettant de constituer un connecteur démontable pour fibre optique en combinant la tête opto-électronique et un embout de fibre optique comportant lui-même un taraudage adapté.

2) L'orifice axial du porte-fibre est complexe: il comporte par exemple trois parties de diamètres internes inégaux. La première partie 51 a un diamètre interne supérieur à celui de la fibre optique pour permettre l'immobilisation de celle-ci par un dépôt de soudure, résine ou colle. La deuxième partie 52, de faible longueur pour permettre le perçage précis de trous de petits diamètres (300), a sensiblement le même diamètre que la fibre optique, mais doit pouvoir cependant laisser celle-ci coulisser librement. La troisième partie 53 comporte un cylindre beaucoup plus large et loge un manchon 54 coulissant à force dans le cylindre. Ce manchon, destiné à être traversé par la fibre, comporte une partie 541 au diamètre de celle-ci, et une partie 542 de plus grand diamètre. Ceci afin de permettre l'usinage de trous de très petit diamètre, impossibles à réaliser économiquement sur de grandes longueurs.

3) La partie inférieure du porte-fibre comporte une entaille 55 destinée à laisser libres les connexions des passages 111 et 112 de l'embase. Cette entaille est nécessaire lorsque les passages 111 et 112 sont situés très près de la périphérie de l'embase, comme cela se présente dans certains modéles (TO 18 TO 46).

4) L'intérieur du boîtier peut être rempli de gaz neutre avant d'opérer la soudure du capot.

Le scellement du capot au niveau de son ouverture supérieure centrale, dans le cas où l'on utilise une préforme de soudure à l'étain à basse température, présente l'avantage de ne pas faire fondre le dépôt de soudure 151( figure 1) et d'éviter de compromettre l'immobilisation de la fibre.

## Revendications

1. Tête de couplage opto-électronique, du type comprenant un dispositif support d'un composant opto-électronique, le composant opto-électronique lui-même, un dispositif de positionnement de fibre optique, dit porte-fibre (16), un tronçon de fibre optique (15), enfin un dispositif d'encapsulation constitué par un boîtier classique de semiconducteur comprenant une embase (11) et un capot (12) percé d'une ouverture circulaire (121) par laquelle le porte-fibre (16) sort du boîtier, le porte-fibre (16) étant maintenu par compression entre cette embase (11) et ce capot (12), ce porte-fibre (16) comportant dans la partie prenant appui sur l'embase (11) un évidement dans lequel se loge le composant opto-électronique (13), caractérisé en ce que le porte-fibre (16) comporte en outre dans sa partie opposée, un épaulement (160), sur la face annulaire duquel s'appuie le bord de cette ouverture circulaire (121) du capot (12) pratiquée dans une partie préalablement emboutie de la partie centrale supérieure de ce capot.

2. Tête de couplage selon la revendication 1, caractérisée en ce qu'elle est rendue étanche par soudure ou collage du bord de l'ouverture (121) du capot sur ledit épaulement, la partie inférieure du capot (12) étant en outre soudée à l'embase (11).

3. Tête de couplage selon la revendication 1, caractérisée en ce que le porte-fibre (16) comporte un canal axial (51) en trois parties de diamètres inégaux, la partie de plus grand diamètre (53) recevant un manchon (54) enserrant le tronçon de fibre optique (15).

4. Procédé de montage d'une tête selon l'une quelconque des revendications 1 à 3, caractérisé en ce qu'il comporte au moins une étape au cours de laquelle, lors de la mise en place du tronçon de fibre (15) dans le porte-fibre (16), on utilise un outillage comportant un plan de référence (200) sur lequel on appuie l'assise du porte-fibre, et une plateforme (201) faisant saillie sur le plan de référence contre laquelle on appuie la face terminale du tronçon de fibre (15) pour fixer la cote de cette face terminale en vue d'obtenir le couplage optimal de la face terminale et du composant opto-électronique.

5. Procédé suivant la revendication 4, caractérisé en ce qu'il comporte en outre une étape dans laquelle on soude le capot (12) sur l'embase (11) en intercalant la tête de couplage entre deux électrodes (41, 42) d'une machine à souder électrique après avoir intercalé de la soudure (18) entre le porte-fibre (16) et le bord de l'ouverture circulaire (121) du capot (12) située à la partie supérieure de celui-ci.

6. Procédé suivant la revendication 5, caractérisé en ce qu'au cours de l'étape dans laquelle on soude le capot (12) sur l'embase (11) une préforme (18) de soudure à l'étain est intercalée entre le porte-fibre (16) et le bord de l'ouverture du capot (12).

## Patentansprüche

1. Optoelektronischer Koppelkopf, bestehend aus einer Trägeranordnung für ein optoelektronisches Bauelement, dem optoelektronischen Bauelement selbst, einer Positionieranordnung für eine Lichtleitfaser, Faserträger (16) genannt, einem Stück (15) Lichtleitfaser und schliesslich aus einer als übliches Halbleitergehäuse ausgebildeten Kapselanordnung, die eine Basis (11) und eine mit einer kreisförmigen Öffnung (121) versehene Haube (12) enthält, wobei der Faserträger (16) durch diese Öffnung aus dem Gehäuse hervortritt und durch Kompression zwischen dieser Basis (11) und dieser Haube (12) gehalten wird und im Bereich, der sich auf der Basis (11) abstützt, einen Hohlraum aufweist, in dem das optoelektronische Bauelement (13) Platz findet, dadurch gekennzeichnet, dass der Faserträger (16) ausserdem in seinem gegenüberliegenden Bereich eine Schulter (160) aufweist, auf deren Ringfläche sich der Rand der kreisförmigen Öffnung (121) der Haube (12) abstützt, wobei die Öffnung in einem vorher eingedrückten Bereich der oberen Mittelzone dieser Haube angebracht ist.

2. Koppelkopf nach Anspruch 1, dadurch gekennzeichnet, dass er durch Schweissen oder Kleben des Randes der Haubenöffnung (121) auf der Schulter abgedichtet ist, wobei der untere Bereich der Haube (12) ausserdem auf die Basis (11) aufgeschweisst ist.

3. Koppelkopf nach Anspruch 1, dadurch gekennzeichnet, dass der Faserträger (16) einen dreiteiligen zentralen Kanal (51) mit unterschiedlichen Durchmessern aufweist, wobei der Teil (53) mit dem grössten Durchmesser eine Muffe (54) aufnimmt, die das Stück Lichtleitfaser (15) umschliesst.

4. Montageverfahren für einen Koppelkopf nach einem der Ansprüche 1 bis 3, dadurch gekennzeichnet, dass es mindestens einen Schritt aufweist, für den man beim Einsetzen des Stücks Lichtleitfaser (15) in den Faserträger (16) ein Werkzeug verwendet, das eine Bezugsebene (200) zum Abstützen der Stirnseite des Faserträgers und eine Plattform (201) aufweist, die über die Bezugsebene vorsteht und gegen die man die Endfläche des Stücks Lichtleitfaser (15) anlegt, um die Lage dieser Endfläche festzulegen, damit man die optimale Kopplung der Endfläche mit dem optoelektronischen Bauteil erhält.

5. Verfahren nach Anspruch 4, dadurch gekennzeichnet, dass es ausserdem einen Verfahrensschritt aufweist, bei dem die Haube (12) auf die Basis (11) aufgeschweisst wird, indem man den Koppelkopf zwischen zwei Elektroden (41, 42) eines Elektroschweissgeräts einlegt, nachdem man Schweissmittel (18) zwischen den Faserträger (16) und den Rand der im oberen Haubenbereich liegenden kreisförmigen Öffnung (121) der Haube (12) eingefügt hat.

6. Verfahren nach Anspruch 5, dadurch gekennzeichnet, dass während des Verfahrensschritts, in dem man die Haube (12) auf die Basis schweisst, ein vorgeformtes Stück Lötzinn (18) zwischen den Faserträger (16) und den Rand der Haube (12) eingefügt ist.

**Claims**

1. Opto-electronic coupling head of the type comprising a support device of an opto-electronic element, the opto-electronic element itself, a positioning device for an optical fibre, called fibre-holder (16), a piece of optical fibre (15), finally an enclosing device constituted by a usual casing of a semiconductor comprising a base (11) and a cover (12) with a circular opening (121) through which the fibre-holder (16) protrudes from the casing, the fibre-holder being held by pressure between said base (11) and said cover (12), the zone of said fibre-holder (16) which rests on the base (11) comprising a free space in which the opto-electronic element (13) is lodged, characterized in that the fibreholder (16) further comprises, in its opposed part, a shoulder (160) on the annular face of which rests the rim of said annular opening (121) of the cover (12), the opening being made in a previously embossed part of the upper central part of said cover.

2. Coupling head according to claim 1, characterized in that it is sealed by welding or gluing of the rim of the opening (121) of the cover on said shoulder, the lower part of the cover (12) being further welded on the base (11).

3. Coupling head according to claim 1, characterized in that the fibre-holder (16) comprises an axial passage (51) having three zones of different diameters, the zone with the largest diameter (53) receiving a muff (54) which squeezes the piece of optical fibre (15).

4. A process for assembling a head according to any one of the claims 1 to 3, characterized in that it comprises at least one step during which, when the piece of fibre (15) is installed in the fibre-holder (16), a tool is used which comprises a reference plane (200) on which rests the seat of the fibre-holder, and a platform (201) protruding from the reference plane and against which abuts the end face of the piece of fibre (15) in order to fix the position of this end face in order to obtain the optimal coupling of the end face and the opto-electronic element.

5. Process according to claim 4, characterized in that it further comprises a step during which the cover (12) is welded on the base (11) by interposing the coupling head between two electrodes (41, 42) of an electric welding machine after having intercalated solder (18) between the fibre-holder (16) and the rim of the circular opening (121) of the cover (12) situated at the upper part of the latter.

6. Process according to claim 5, characterized in that during the step in which the cover (12) is welded on the base (11), a preformed piece (18) of solder is intercalated between the fibre-holder (16) and the rim of the opening of the cover (12).

FIG.1

FIG.2

FIG.3

FIG.4

FIG.5